(19) **Europäisches Patentamt European Patent Office Office européen des brevets**

(11) **EP 3 402 018 A1**

(12) **EUROPEAN PATENT APPLICATION**

(43) Date of publication:
**14.11.2018 Bulletin 2018/46**

(51) Int Cl.:
**H01S 5/34** (2006.01)          **H01S 5/347** (2006.01)
**H01S 5/50** (2006.01)

(21) Application number: **17170479.4**

(22) Date of filing: **10.05.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Universiteit Gent
9000 Gent (BE)**

(72) Inventors:
• **HENS, Zeger
  9000 Gent (BE)**
• **GEIREGAT, Pieter
  9040 Sint-Amandsberg (BE)**

(74) Representative: **Gevers Patents
Intellectual Property House
Holidaystraat 5
1831 Diegem (BE)**

(54) **LIGHT AMPLIFICATION METHOD USING AN OPTICAL GAIN MEDIUM COMPRISING QUANTUM DOTS**

(57)     The present invention relates to an optical gain medium (2) comprising colloidal semiconductor quantum dots (3) and a light amplification method using the optical gain medium (2). The quantum dots (3) are preferably HgTe quantum dots. The optical gain medium (2) can be pumped by continuous wave exciting light (11) at low power density. It can therefore be used to amplify sun light.

Figure 1

## Description

## Field of the invention

According to a first aspect, the present invention relates to a light amplification method. According to a second aspect, the present invention relates to an optical gain medium.

## Background of the invention

In an optical gain medium, exciting light in a first wavelength range can be used as an optical pump in such a way that the medium emits and then amplifies light in a second wavelength range. The power density threshold of such an optical gain medium is defined as the minimum power density required to obtain optical gain.

It is desirable, for example for solar panels, to have an optical gain medium where the sun light can be used as pumping light, and then be amplified. Such an optical gain medium should be able to work with an exciting light that is continuous wave light. Moreover, such an optical gain medium must have a low power density threshold since the total solar irradiance only amounts approximately to 100 mW/cm$^2$, the total solar irradiance being the power per unit area of sunlight integrated over all wavelengths.

The PhD thesis of Pieter Geiregat, called "Colloidal Quantum Dots for Guided Wave Photonics : from Optical Gain to Ultrafast Modulation", Universiteit Gent, 2015, discloses an optical gain medium comprising HgTe quantum dots that provides optical gain at low power density. This low power density threshold is explained by a model wherein a single electron in the conduction band is coupled to both the valence band and a band gap intermediate state. This model involves a transition of a conduction band electron to a band gap intermediate state that is empty in unexcited quantum dots or a transition of a valence band hole to an occupied band gap intermediate state that have no counterpart in absorption. This PhD thesis describes that the lifetime of the excited state that gives rise to the optical transition with the low power density threshold has been determined by measuring the decay of the luminescence signal at various time delays and has been found in the range 20 to 40 ns.

Such a lifetime requires the excitation of many quantum dots at the same time to obtain amplification, which cannot be achieved by continuous wave pumping. Therefore, according to this PhD thesis, the HgTe quantum dots would be unable to provide amplification for continuous wave pumping at low power density. That would make the HgTe quantum dots unsuitable for amplification of solar light.

Document WO2015/186033 discloses a gain medium working with continuous wave pumping. The gain medium consists in a film of colloidal nanocrystals of semiconductor material. The nanocrystals are two-dimensional nanocrystals. Continuous wave light amplification occurs due to a biexciton gain mechanism. In the gain medium presented in WO2015/186033, the power density threshold of the optical pump is equal to 6,5 W/cm$^2$ for continuous wave pumping, which is too high to obtain amplification induced by solar light.

## Summary of the invention

According to a first aspect, an object of the invention is to provide a light amplification method that can achieve continuous wave light amplification under low power density continuous wave optical pumping.

According to this first aspect, the invention a light amplification method for amplifying light coming from a light source, the light amplification method comprising the steps of:

(a) providing an optical gain medium comprising colloidal semiconductor quantum dots having a band gap intermediate state between a valence band and a conduction band, the band gap intermediate state being unoccupied at equilibrium, the quantum dots being able to be excited by exciting light in a first wavelength range corresponding to a transition between the valence band and the conduction band, and to amplify emitted light in a second wavelength range corresponding to an optically active electronic transition involving the band gap intermediate state, the wavelengths in the second wavelength range being higher than the wavelengths in the first wavelength range,
(b) receiving, from said light source and with said gain medium, exciting light in the first wavelength range to generate a transition from the valence band to the conduction band,
(c) emitting, with said gain medium, emitted light in the second wavelength range by a transition involving the band gap intermediate state,

characterized in that the exciting light received at step (b) is a continuous wave light.

The optically active electronic transition involving the band gap intermediate state can be called a sub-bandgap transition. It involves a difference of energy lower than the band gap transition. It can be a transition between the conduction band and the band gap intermediate state, between the band gap intermediate state and the valence band or between the band gap intermediate state and a second band gap intermediate state.

The inventors have shown that the power density threshold for the amplification of spontaneous emission under continuous wave light excitation by colloidal semiconductor quantum dots having such a sub-bandgap transition can be as low as 40 mW/cm$^2$, which is considerably better than the power density threshold of 6,5 W/cm$^2$ indicated in document WO2015/186033. Colloidal semiconductor quantum dots having a sub-band-

gap transition are therefore able to meet the requirements for emission induced by solar light and for DC electrical pumping. Moreover, a modal gain of up to 2.1 cm$^{-1}$ in a optical gain medium comprising such quantum dots was demonstrated by the inventors under continuous wave light excitation and under pulsed excitation, the modal gain being the gain achieved by the guided optical mode of the photonic structure. The material gain can be substantially higher due to low confinement of the guided mode in the quantum dot-enriched region of the slab.

Amplification of continuous wave light by the quantum dots is possible because of the sub-bandgap transition and because the lifetime of the excited state that gives rise to the optically active sub-bandgap transition with the low power density threshold can be around 28 $\mu$s, which is much longer than the lifetime of 20 to 40 ns disclosed in the PhD of Pieter Geigerat. It is therefore possible to achieve, with continuous wave pumping, excitation of enough quantum dots to obtain amplification.

The inventors can explain the long lifetime of the excited state by a model involving two types of quantum dots. The quantum dots of the first type are intrinsic and show fast band-to-band decay. They do not contribute to the light amplification. The quantum dots of the second type have the band gap intermediate state and fall back to the valence band following the sub-bandgap transition and another transition. This other transition can be non-radiative. For example, a non-radiative transition can bring the quantum dot from the conduction band to the band gap intermediate state having a long lifetime and then the optically active sub-bandgap transition can happen between the band gap intermediate state and the valence band. This model is fundamentally different from the model disclosed in the PhD of Pieter Geigerat wherein a single electron in the conduction band is coupled together to the valence band and to the band gap intermediate state.

Actually, the inventors have shown that in such quantum dots, excitation to the conduction band caused by continuous wave light is followed by the spontaneous emission of light through the sub-bandgap transition. Since the band gap intermediate state is unoccupied at equilibrium, the sub-bandgap transition occurs at wavelengths where the quantum dots are transparent, meaning that the emitted light is not reabsorbed by the quantum dots. The emitted light can then generate stimulated emission in another quantum dot, which creates optical amplification. As a result, stimulated emission involving this transition leads to net optical gain as attested, for example, by the amplification of the spontaneous emission at very low levels of pumping power.

The fact that colloidal semiconductor quantum dots can provide such a low power density threshold and a good modal gain is surprising. Typically, stimulated emission across the band-gap transition is utilized to achieve optical amplification. Since these band-edge states are degenerate, quantum dots must contain more than one exciton on average to achieve population inversion. Next to this intrinsic drawback of 2-level gain media, multi-excitons rapidly recombine through non-radiative Auger processes, which limits the population inversion lifetime to a few tens of picoseconds. This makes that optical amplification is mostly only achieved using femtosecond pulsed illumination. All this indicates that quantum dots are not expected to provide good optical amplification characteristics.

The band gap intermediate state is due to the presence of defects in the crystal structure or ill passivated sites at the quantum dot surface that create a surface-localized gap state. Such defects or ill passivated sites are often seen as disadvantageous for the optical properties of colloidal quantum dots. For example, the extend of surface passivation has been explicitly linked to a low photoluminenescence quantum yield of colloidal quantum dots. From a similar perspective, US6819692B2 emphasizes that optical gain characteristics of nanocrystal solids will be better with longer non-radiative lifetime of multi-excitons. Hence, defects that trap electrons or holes are generally expected to be disadvantageous for optical gain.

An advantage of colloidal quantum dots is that the emission wavelength can be tuned by tuning the size of the quantum dots. Another advantage is that the colloidal quantum dots are easy and cheap to produce.

An advantage of continuous wave excitation over pulsed excitation is that the amplification happens continuously instead of happening by pulses.

In an embodiment of the invention, the exciting light received at step (b) has a power density below 1 W/cm$^2$, preferably below 100 mW/cm$^2$, more preferably below 50 mW/cm$^2$.

In an embodiment of the invention, the quantum dots comprise ZnO, ZnS, ZnSe, ZnTe, CdO, CdS, CdSe, CdTe, MgO, MgS, MgSe, MgTe, HgO, HgS, HgSe, HgTe, AlN, AlP, AlAs, AlSb, GaN, GaP, GaAs, GaSb, InN, InP, InAs, InSb, TlN, TlP, TlAs, TlSb, TlSb, PbS, PbSe, PbTe, or mixtures thereof.

In an embodiment of the invention, the quantum dots comprise HgTe, preferably are HgTe quantum dots.

In an embodiment of the invention, the band gap intermediate state is a surface-localized gap state. It is especially advantageous because the amplification can be tuned by washing the optical gain medium.

According to a second aspect, the invention provides an optical gain medium comprising colloidal semiconductor quantum dots having a band gap intermediate state between a valence band and a conduction band, the band gap intermediate state being unoccupied at equilibrium, the quantum dots being able to be excited by exciting light in a first wavelength range corresponding to a transition between the valence band and the conduction band, and to amplify emitted light in a second wavelength range corresponding to an optically active electronic transition involving the band gap intermediate state, the wavelengths in the second wavelength range being higher than the wavelengths in the first wavelength range.

Any embodiment of an optical gain medium described in the present document can be used in the light amplification method according to the invention.

In an embodiment of the invention, the quantum dots comprise ZnO, ZnS, ZnSe, ZnTe, CdO, CdS, CdSe, CdTe, MgO, MgS, MgSe, MgTe, HgO, HgS, HgSe, HgTe, AlN, AlP, AlAs, AlSb, GaN, GaP, GaAs, GaSb, InN, InP, InAs, InSb, TlN, TlP, TlAs, TlSb, TlSb, PbS, PbSe, PbTe, or mixtures thereof.

In an embodiment of the invention, the quantum dots comprise HgTe, preferably are HgTe quantum dots.

In an embodiment of the invention, the quantum dots have an average diameter between 1 and 20 nm, preferably between 2 and 10 nm, more preferably between 3.0 and 4.0 nm.

In an embodiment of the invention, the dispersion medium is a liquid, for example toluene. It makes possible to give any shape to the optical gain medium.

In an embodiment of the invention, the dispersion medium is a flexible solid. It makes the optical gain medium especially solid and easy to handle.

The invention also provides a luminescent solar concentrator comprising the optical gain medium according to an embodiment of the invention.

In an embodiment of the invention, the optical gain medium is arranged for receiving continuous wave exciting light, for example continuous wave light coming from the sun, from a first direction and to emit amplified light in a second direction, and the luminescent solar concentrator comprises an output device arranged in the second direction to receive the light emitted by the optical gain medium. The second direction is different from the first direction. The second direction may be essentially perpendicular to the first direction.

In an embodiment of the invention, the output device comprises a photovoltaic cell.

The invention also provides a light emitting device comprising:

- an optical gain medium according to an embodiment of the invention, and
- a continuous wave light source arranged to provide continuous wave exciting light in the first wavelength range to the optical gain medium.

In an embodiment of the invention, the continuous wave light source is arranged to provide light at a power density below 1 W/cm$^2$, preferably below 100 mW/cm$^2$, even more preferably below 50 W/cm$^2$.

The invention also provides a laser comprising:

- an optical cavity,
- a light emitting device according to an embodiment of the invention, wherein the optical gain medium is arranged inside the optical cavity. The invention also provides an electronic circuit comprising:
- a connecting device comprising a light emitting device according to an embodiment of the invention, and
- an electronic device arranged to receive the light emitted by the connecting device.

**Brief description of the figures**

For a better understanding of the present invention, reference will now be made, by way of example, to the accompanying drawings in which:

- Figure 1 schematically illustrates a light source and an optical gain medium according to an embodiment of the invention,
- Figure 2a schematically illustrates a spontaneous emission and Figure 2b schematically illustrates a stimulated emission according to an embodiment of the invention.
- Figure 3a schematically illustrates a spontaneous emission and Figure 3b schematically illustrates a stimulated emission according to an embodiment of the invention,
- Figure 4 shows a plot of the absorbance and emission of HgTe quantum dots suspended in trichloroethylene,
- Figure 5a illustrates the light output versus optically pumped pump power for an embodiment of the invention where the quantum dots are HgTe quantum dots and the dispersion medium is PMMA,
- Figure 5b illustrates the light output versus stripe length of the device for an embodiment of the invention where the quantum dots are HgTe quantum dots and the dispersion medium is PMMA,
- Figure 6a shows the photoluminescence intensity of a solid film obtained through dropcasting, containing 1 vol% HgTe quantum dots and 99 vol% polymer host,
- Figure 6b shows the fraction of the second contribution to the total emission as function of the temperature,
- Figure 7a shows a non-linear absorption spectra, taken 2.5 ns after photo-excitation for different pump fluences which correspond to different exciton densities <N> in an embodiment of the invention where the quantum dots are HgTe quantum dots,
- Figure 7b shows the wavelength dependent gain threshold as obtained from the plots of Figure 7a,
- Figure 8 illustrates the luminesce decay of the HgTe quantum dots dispersed in a solvent, and
- Figure 9 shows the gain cross section and the photoluminescent quantum yield as function of the number of washing steps for an embodiment of the invention where the quantum dots are HgTe quantum dots and the dispersion medium is PMMA.

**Description of the invention**

The present invention will be described with respect to particular embodiments and with reference to certain drawings but the invention is not limited thereto. The drawings described are only schematic and are nonlimiting. In the drawings, the size of some of the elements may be exaggerated and not drawn on scale for illustrative purposes.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Furthermore, the various embodiments, although referred to as "preferred" are to be construed as exemplary manners in which the invention may be implemented rather than as limiting the scope of the invention.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present invention, the only enumerated components of the device are A and B, and further the claim should be interpreted as including equivalents of those components.

On the figures, identical or analogous elements may be referred by a same number.

In the frame of the present document, a "continuous wave light" is a light which is continuous in time over a period of at least 30 $\mu$s, preferably at least one second, more preferably at least 60 seconds..

In the frame of the present document, the "optical gain", g, is the the increase of light intensity I per unit of propagation length L. It is such as

$$I = I_0 \exp(g^*L)$$

In the frame of the present document, a "state unoccupied at equilibrium" is an energy state which cannot be reached without excitation at temperature below the equilibrium temperature of the system.

In the frame of the present document, the "exciton density", noted $<N>$, is defined as the average number of electron-hole pairs per quantum dot, either at time zero for pulsed excitation, or as time-averaged for the continuous wave experiments. The probability to have N electron-hole pairs is expected to be given by a Poisson distribution with mean $<N>$, i.e. $P(N) = \exp(-<N>)$ $<N>^N/N!$.

In the frame of the present document, the "gain threshold", also called the threshold $<N>$ is , for every wavelength, defined as the average number of electron-hole pairs per quantum dot needed to achieve transparency (zero absorbance or a perfect balance between absorption and stimulated emission) at that wavelength.

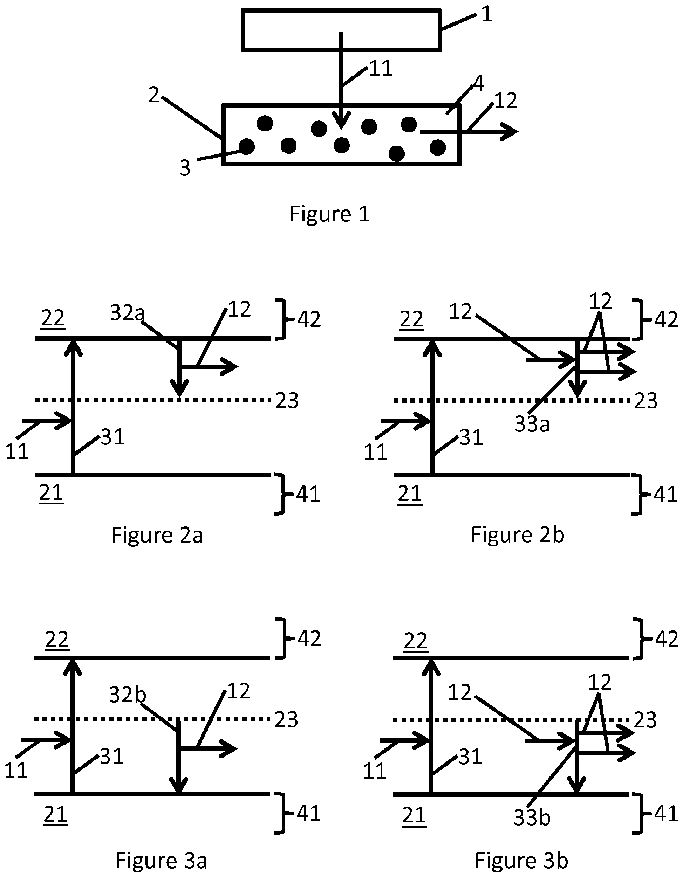

Figure 1 schematically illustrates a light source 1 emitting continuous wave light, which is an exciting light 11, and an optical gain medium 2 comprising colloidal semiconductor quantum dots 3 and a dispersion medium 4. The optical gain medium 2 receives the exciting light 11 and, in response to the exciting light 11, emits amplified emitted light 12.

In an embodiment of the invention, the light source 1 is a device. In that case, the light source 1 and the optical gain medium 2 can be part of a light emitting device according to the invention. In another embodiment of the invention, the light source 1 is the sun.

The exciting light 11, which can be called pumping light, is in a first wavelength range. The first wavelength range is preferably at least partially below 1250 nm, more preferably totally below 1250 nm. The first wavelength range preferably corresponds to wavelengths that are absorbed by the quantum dots 3. The first wavelength range preferably corresponds to a range of energy higher than the band gap of the quantum dots 3.

The quantum dots 3 have preferably an average diameter between 1 and 20 nm, more preferably between 2 and 10 nm, even more preferably between 3.0 and 4.0 nm.

The quantum dots 3 preferably comprises ZnO, ZnS, ZnSe, ZnTe, CdO, CdS, CdSe, CdTe, MgO, MgS, MgSe, MgTe, HgO, HgS, HgSe, HgTe, AlN, AlP, AlAs, AlSb, GaN, GaP, GaAs, GaSb, InN, InP, InAs, InSb, TlN, TlP, TlAs, TlSb, TlSb, PbS, PbSe, PbTe or mixtures thereof.

The quantum dots 3 are preferably ZnO, ZnS, ZnSe, ZnTe, CdO, CdS, CdSe, CdTe, MgO, MgS, MgSe, MgTe, HgO, HgS, HgSe, HgTe, AlN, AlP, AlAs, AlSb, GaN, GaP, GaAs, GaSb, InN, InP, InAs, InSb, TlN, TlP, TlAs, TlSb, TlSb, PbS, PbSe, PbTe quantum dots or mixtures thereof.

The quantum dots 3 are dispersed in the dispersion medium 4. In an embodiment of the invention, the dispersion medium 4 is a liquid, for example toluene. In an embodiment of the invention, the dispersion medium 4 is a flexible solid, for example a PMMA (polymethylmethacrylate) film. In that case, the optical gain medium 2 comprises a nanocomposite made of the flexible solid and the quantum dots 3.

The emitted light 12 is generated and then amplified by the quantum dots 3. The emitted light 12 has a longer wavelength than the exciting light 11. The emitted light 12 is in a second wavelength range. The wavelengths in the second wavelength range are higher than the wavelengths in the first wavelength range. The second wavelength range is preferably at least partially between 1100 nm and 1400 nm.

The dispersion medium 4 is preferably transparent in the first and the second wavelength ranges.

The quantum dots 3 do not absorb light in the second wavelength range because the band gap intermediate state 23 is empty at equilibrium. This will be described with reference to Figures 2 and 3.

If the light source 1 is the sun, the optical gain medium 2 is preferably comprised in a luminescent light concentrator. The luminescent light concentrator also preferably comprises an output device, which can comprise a photovoltaic cell. In an embodiment of the invention, the optical gain medium 2 is arranged for receiving continuous wave light 11 coming from the sun from a first direction and to emit amplified light in a second direction, and the output device is arranged in the second direction to receive the light 12 emitted by the optical gain medium.

Figure 2a schematically illustrates a spontaneous emission 32a and Figure 2b schematically illustrates a stimulated emission 33a according to an embodiment of the invention. Figure 3a schematically illustrates a spontaneous emission 32b and Figure 3b schematically illustrates a stimulated emission 33b according to an embodiment of the invention.

The quantum dots 3 have a band gap between their valence band 21 and their conduction band 22. The valence band 21 comprises a plurality of energy states 41. The conduction band 22 comprises a plurality of energy states 42. A band gap intermediate state 23 is present in the band gap. The band gap intermediate state 23 is far enough from the valence band 21 to be unoccupied at equilibrium.

At equilibrium, the conduction band 22 is empty. The exciting light 11 excites an electron of the quantum dot 3 to the conduction band 22 by a pumping transition 31.

In the embodiment of the invention illustrated at Figure 2a, an electron in a first quantum dot 3 goes down to the band gap intermediate state 23 by a spontaneous emission, which is an optically active electronic transition 32a. This spontaneous emission 32a generates emitted light 12. Then, as illustrated at Figure 2b, an electron in a second quantum dot 3 goes down to the band gap intermediate state 23 by a stimulated emission, which is an optically active electronic transition 33a. This stimulated emission 33a is caused by the light 12 emitted by the spontaneous emission of the first quantum dot 3 and received by the second quantum dot 3. The stimulated emission 33a results in two photons of emitted light 12. Therefore, as a result, the emitted light 12 is amplified by the second quantum dots. Later, the electron will go back to the valence band 21 by a further transition, which may be radiative or non-radiative.

In the case illustrated by Figures 2a and 2b, the optically active electronic transition 32a, 33a involving the band gap intermediate state 23 is the transition between the conduction band 22 and the band gap intermediate state 23. The excited state that gives rise to the optically active electronic transition 32a, 33a is one of the energy states 42 of the conduction band 22.

In the embodiment of the invention illustrated at Figure 3a, an electron in a first quantum dot 3 goes down to the band gap intermediate state 23 by a first transition, which may be radiative or non-radiative. Then, the electron goes down the band gap intermediate state 23 by a spontaneous emission, which is an optically active electronic transition 32b. This spontaneous emission 32b generates emitted light 12. Then, as illustrated at Figure 3b, an electron in a second quantum dot 3 goes down from the band gap intermediate state 23 to the valence band 21 by a stimulated emission, which is an optically active electronic transition 33b. The stimulated emission 33b is due to the light 12 emitted by the spontaneous emission of the first quantum dot 3. The stimulated emission 33b results in two photons of emitted 12. Therefore, as a result, the emitted light 12 is amplified by the second quantum dot 3.

In the case illustrated by Figures 3a and 3b, the optically active electronic transition 32b, 33b involving the band gap intermediate state 23 is the transition between the band gap intermediate state 23 and one of the energy states 41 of the valence band 21. The excited state that gives rise to the optically active electronic transition 32b, 33b is the band gap intermediate state 23.

It is also possible that the optically active electronic transition involving the band gap intermediate state 23 is a transition between the band gap intermediate state 23 and a lower band gap intermediate state.

Since the band gap intermediate state 23 is unoccupied at equilibrium, there is no absorption at the wavelength of the emitted light 12.

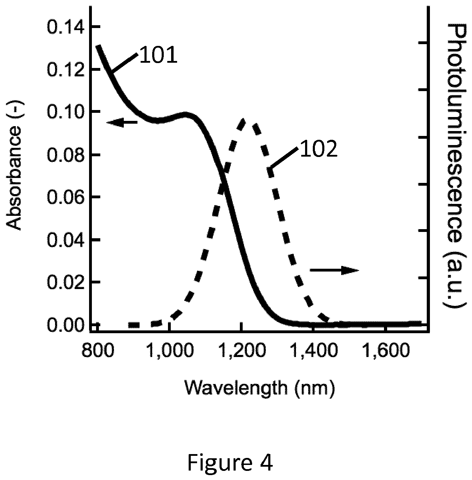

The quantum dots 3 used in the experiments resulting in the plots illustrated in the Figures 4 to 9 are HgTe quantum dots that were prepared with the following process.

270 mg (1 mmol) of $HgCl_2$, 1.6 mL (6 mmol) of dodecanethiol (DDT) and 8 mL of oleylamine (OLA) were mixed in a 25 mL flask and degassed under vacuum at 100°C for one hour, after which the reaction mixture was placed under nitrogen while keeping the temperature at 60°C. Next, 1 mL of a 1 M solution of tellurium in trioctylphosphine was rapidly injected and a black-colored reaction mixture was obtained within a few seconds. The reaction mixture was kept at the injection temperature to allow for quantum dot growth for 1 minute (1220 nm emission) to 3 minutes (1300 nm emission), after which the reaction was quenched by injecting 10 mL of toluene and cooling with a water bath. As obtained HgTe quantum dots were purified twice using toluene and methanol.

In the case where the dispersion medium 4 is a flexible solid, the following further steps were used. PMMA (polymethyl-methacrylate) with a molecular weight of 120,000 and a mass density of 1.19 $g/cm^3$ was used. 0.96 g of PMMA was dissolved in 10 mL of toluene to obtain a 5 m% solution. From this stock solution, 1 mL was mixed with a given HgTe quantum dot solution in toluene to obtain a volume fraction of quantum dots of 0.1 to 1 % relative to PMMA. These composites were dropcast or spincoated on glass substrates to achieve different film thicknesses of a few 100 nm to several 100 $\mu$m. For the ASE/VSL measurements the films were delaminated, yielding a flexible and free-standing hybrid polymer/quantum dot lightguide and put on a support.

Figure 4 shows a plot of the absorbance 101 and emission 102 of HgTe quantum dots suspended in trichloroethylene. The emission can be called photoluminescence. It is visible that the quantum dots 3 absorb exciting light 11 mainly below 1100 nm, which preferably corresponds to the first wavelength range, and emit light 12 mainly between 1100 nm and 1400 nm, which preferably corresponds to the second wavelength range.

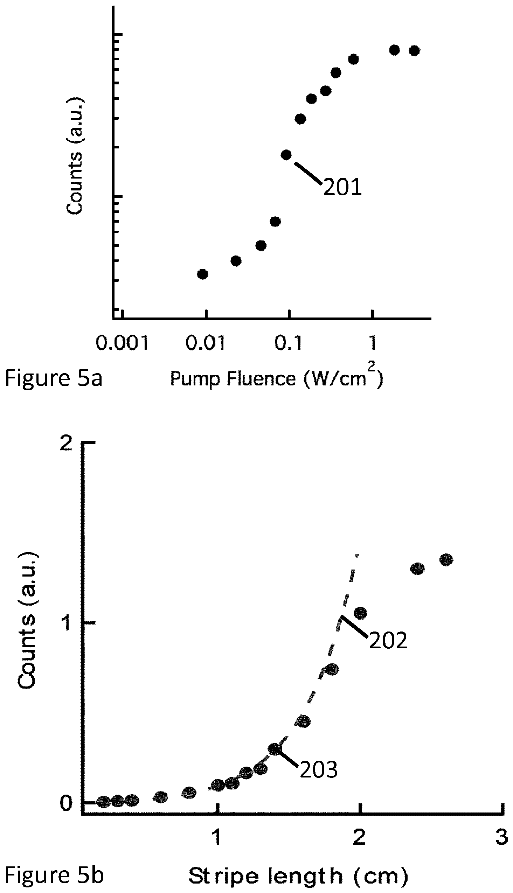

Figures 5a and 5b illustrate the light output of the 1 D amplifier (made by illuminating a stripe on the 2D PMMA/HgTe film) as a function of pump power (Figure 5a) and stripe length (Figure 5b). The exciting light 11 is at 447 nm. Figure 5a shows a plot 201 as function of the fluence of the exciting light 11. A power density threshold of 40 mW/cm$^2$ is extracted from this plot by fitting an exponential. Figure 5b shows a plot 202 of as function of the length of the optical gain medium 2. A net modal gain coefficient of 2.4 cm$^{-1}$ is extracted from this plot by fitting an exponential 203. Figures 5a and 5b indicate a supralinear increase pointing towards light amplification of the type: $\exp(g(P)*L)$ where L is the stripe length pumped and $g(P)$ is the gain (per cm, per mW) at a power of P. The supralinear output with pump power and increasing stripe length is a clear indication of light amplification.

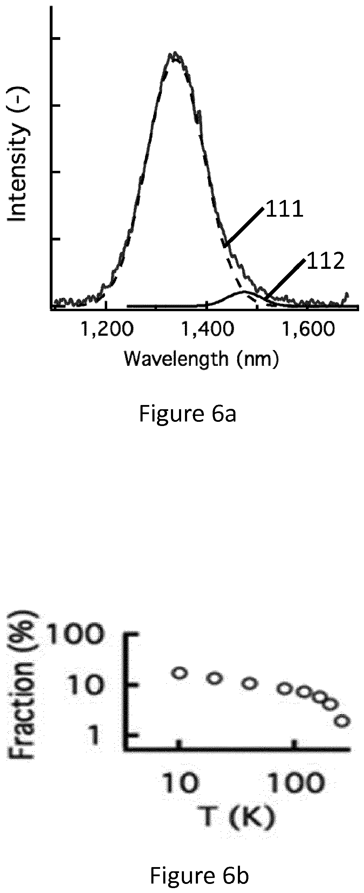

Figure 6a shows the photoluminescence intensity of a solid film obtained through dropcasting, containing 1 vol% HgTe quantum dots and 99 vol% polymer host after 700 nm excitation. The measured peak has two contributions. A first contribution 111 comes from quantum dots 3 following a radiative transition from the conduction band 22 to the valence band 21. In other words, the first contribution 111 comes from quantum dots 3 of a first type, which are intrinsic and show fast band-to-band decay. The wavelength range of first contribution 111 is the first wavelength range. Light in this first wavelength range is absorbed by the quantum dots 3. A second contribution 112 comes from quantum dots 3 following the transition scheme illustrated at Figures 2a and 2b. In other words, the second contribution 112 comes from quantum dots 3 of a second type, which have the band gap intermediate state 23 and fall back to the valence band 21 following the sub-bandgap transition and another transition. The wavelength range of second contribution 112 is the second wavelength range. Light in this second wavelength range is emitted by the quantum dots 3. It clearly appears that the contributions 111, 112 does not have their peak at the same wavelength. In other words, there is no linear absorption of the quantum dots 3 at the wavelengths of emission of the emitted light 12.

Figure 6b shows the fraction of the second contribution to the total emission as function of the temperature. These values were extracted from plots equivalent to Figure 6a at various temperatures.

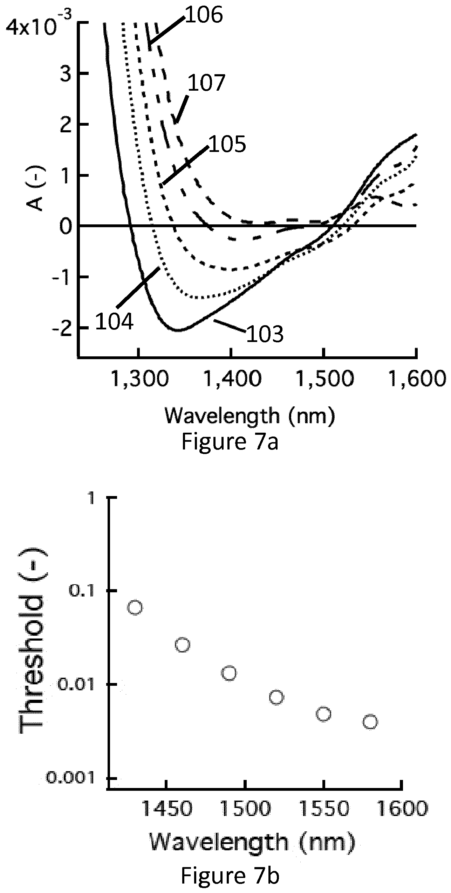

Figure 7a shows a non-linear absorption spectra, taken 2.5 ns after photo-excitation for different pump fluences which correspond to different exciton densities <N>. The exciton density is equal to 0.3 for plot 103, 0.12 for plot 104, 0.06 for plot 105, 0.03 for plot 106 and 0.006 for plot 107. The delay of 2.5 ns strongly exceeds the lifetime of multi-excitons, such that quantum dots contain a single exciton at the most.

Figure 7b shows the wavelength dependent gain threshold as obtained from the plots of Figure 7a. Figure 7b explicitly shows that HgTe quantum dots reach transparency at thresholds (N) dropping to 0.005 beyond 1450 nm. A threshold (N) value of 0.01 indicates that only one electron-hole pair per quantum dot out of hundred needs to be excited to get light amplification.

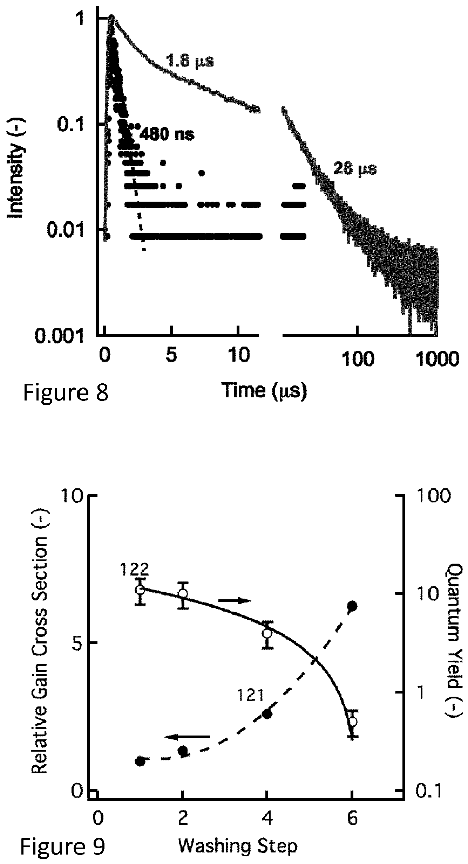

Figure 8 illustrates the luminesce decay of the HgTe quantum dots dispersed in a solvent. The fast decay (480 ns) is due to direct transitions between levels 22 to 21 (Figure 2a) and the slow decay (several microseconds) is due to the transition from levels 22 to 23, i.e. the gain transition. Clearly, the gain state is long lived, a requisite for achieving continuous wave gain.

To further identify the origin of the gap states involved, the inventors have analyzed the optical gain after repetitive washing of an optical gain medium 2 where the dispersion medium 4 is PMMA.

Repetitive washing is known to displace surface passivating moieties, induce dangling bonds at the quantum dots surface and reduce the photoluminescent quantum yield (PLQY), which is the ratio between the number of photons emitted and absorbed by the quantum dots. As illustrated at Figure 9, the inventors have found that increased washing yields a strong increase in the gain cross section 121 and a concomitant decrease in PLQY 122. This seems to indicate that the optically active electronic transition involves a band gap intermediate state 23 at the HgTe surface, possibly created by Te dangling bonds after Hg-thiolate removal upon washing. The gain cross section is related to the material gain gi as: gi x volume = cross section.

Even if the present document mainly refers to HgTe quantum dots, other quantum dots able to be excited by exciting light 11 in a first wavelength range corresponding to a transition 31 between the valence band 21 and the conduction band 22, and to amplify emitted light 12 in a second wavelength range corresponding to optically active electronic transition 32a, 32b, 33a, 33b involving a band gap intermediate state 23 which is unoccupied at equilibrium will exhibit similar characteristics as the HgTe quantum dots.

Although the present invention has been described above with respect to particular embodiments, it will readily be appreciated that other embodiments are also possible.

# Claims

1. Light amplification method for amplifying light coming from a light source (1), the light amplification method comprising the steps of:

   (a) providing an optical gain medium (2) comprising colloidal semiconductor quantum dots (3) having a band gap intermediate state (23) between a valence band (21) and a conduction band (22), the band gap intermediate state (23) being unoccupied at equilibrium, the quantum dots (3) being able to be excited by exciting light (11) in a first wavelength range corresponding to a transition (31) between the valence band (21) and the conduction band (22), and to amplify emitted light (12) in a second wavelength range corresponding to an optically active electronic transition (32a, 32b, 33a, 33b) involving the band gap intermediate state (23), the wavelengths in the second wavelength range being higher than the wavelengths in the first wavelength range,
   (b) receiving, from said light source (1) and with said gain medium (2), exciting light (11) in the first wavelength range to generate a transition (31) from the valence band (21) to the conduction band (22),
   (c) emitting, with said gain medium (2), emitted light (12) in the second wavelength range by a transition (32a, 32b, 33a, 33b) involving the band gap intermediate state (23),

   **characterized in that** the exciting light (11) received at step (b) is a continuous wave light.

2. Light amplification method according to claim 1, **characterized in that** the exciting light (11) received at step (b) has a power density below 1 W/cm$^2$, preferably below 100 mW/cm$^2$, more preferably below 50 mW/cm$^2$.

3. Light amplification method according to claim 1 or 2, **characterized in that** the quantum dots (3) comprise ZnO, ZnS, ZnSe, ZnTe, CdO, CdS, CdSe, CdTe, MgO, MgS, MgSe, MgTe, HgO, HgS, HgSe, HgTe, AlN, AlP, AlAs, AlSb, GaN, GaP, GaAs, GaSb, InN, InP, InAs, InSb, TlN, TlP, TlAs, TlSb, TlSb, PbS, PbSe, PbTe, or mixtures thereof.

4. Light amplification method according to the preceding claim, **characterized in that** the quantum dots (3) comprise HgTe, preferably are HgTe quantum dots.

5. Light amplification method according to any of the preceding claims, **characterized in that** the band gap intermediate state (23) is a surface-localized gap state.

6. Optical gain medium (2) comprising colloidal semiconductor quantum dots (3) having a band gap intermediate state (23) between a valence band (21) and a conduction band (22), the band gap intermediate state (23) being unoccupied at equilibrium, the quantum dots (3) being able to be excited by exciting light (11) in a first wavelength range corresponding to a transition (31) between the valence band (21) and the conduction band (22), and to amplify emitted light (12) in a second wavelength range corresponding to an optically active electronic transition (32a, 32b, 33a, 33b) involving the band gap intermediate state (23), the wavelengths in the second wavelength range being higher than the wavelengths in the first wavelength range.

7. Optical gain medium (2) according to the preceding claim, **characterized in that** the quantum dots (3) comprise ZnO, ZnS, ZnSe, ZnTe, CdO, CdS, CdSe, CdTe, MgO, MgS, MgSe, MgTe, HgO, HgS, HgSe, HgTe, AlN, AlP, AlAs, AlSb, GaN, GaP, GaAs, GaSb, InN, InP, InAs, InSb, TlN, TlP, TlAs, TlSb, TlSb, PbS, PbSe, PbTe, or mixtures thereof.

8. Optical gain medium (2) according to the preceding claim, **characterized in that** the quantum dots (3) comprise HgTe, preferably are HgTe quantum dots.

9. Optical gain medium (2) according to any of claims 6 to 8, **characterized in that** the quantum dots (3) have an average diameter between 1 and 20 nm, preferably between 2 and 10 nm, more preferably between 3.0 and 4.0 nm.

10. Optical gain medium according to any of claims 6 to 9, **characterized in that** the dispersion medium (4) is a liquid, for example toluene.

11. Optical gain medium according to any of claims 6 to 9, **characterized in that** the dispersion medium (4) is a flexible solid.

12. Luminescent solar concentrator comprising the optical gain medium (2) according to any of claims 6 to 11.

13. Luminescent solar concentrator according to the preceding claim wherein the optical gain medium (2) is arranged for receiving continuous wave exciting light (11), for example continuous wave light coming from the sun, from a first direction and to emit amplified light (12) in a second direction, and comprising an output device arranged in the second direction to receive the light (12) emitted by the optical gain medium (2).

**14.** Luminescent solar concentrator according to the preceding claim, **characterized in that** the output device comprises a photovoltaic cell.

**15.** Light emitting device comprising:

• an optical gain medium according to any of claims 6 to 11, and
• a continuous wave light source (1) arranged to provide continuous wave exciting light (11) in the first wavelength range to the optical gain medium (2).

**16.** Light emitting device according to the preceding claim, **characterized in that** the continuous wave light source (1) is arranged to provide light (11) at a power density below 1 W/cm$^2$, preferably below 100 mW/cm$^2$, more preferably below 50 mW/cm$^2$.

Figure 1

Figure 2a

Figure 2b

Figure 3a

Figure 3b

Figure 4

EP 3 402 018 A1

Figure 5a

Figure 5b

Figure 6a

Figure 6b

Figure 7a

Figure 7b

Figure 8

Figure 9

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | Pieter Geiregat: "Colloidal quantum dots for guided wave photonics : from optical gain to ultrafast modulation -Dissertation", 2015, Ghent University. Faculty of Engineering and Architecture ; Faculty of Sciences, XP002776627, ISBN: 9789085787662 pages Frontpg-XXV, 1-259, * part 7.5.2 * | 6-10 | INV. H01S5/34 H01S5/347 H01S5/50 |
| A,D | WO 2015/186033 A1 (FOND ISTITUTO ITALIANO DI TECNOLOGIA [IT]) 10 December 2015 (2015-12-10) * abstract * | 1-16 | |
| X | CHENG CHENG ET AL: "Experimental Realization of a PbSe-Quantum-Dot Doped Fiber Laser", IEEE PHOTONICS TECHNOLOGY LETTERS, IEEE SERVICE CENTER, PISCATAWAY, NJ, US, vol. 25, no. 6, 1 March 2013 (2013-03-01), pages 572-575, XP011495787, ISSN: 1041-1135, DOI: 10.1109/LPT.2013.2243139 * abstract * | 1-16 | |
| X | BARBOSA: "Luminescence of PbS quantum dots on a silica microstructured fiber", SPIE, PO BOX 10 BELLINGHAM WA 98227-0010 USA, 2010, XP040523666, * abstract * * Introduction * | 1,6 | |

TECHNICAL FIELDS SEARCHED (IPC)

H01S

-/--

The present search report has been drawn up for all claims

| Place of search | Date of completion of the search | Examiner |
|---|---|---|
| Munich | 21 December 2017 | Lendroit, Stéphane |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 17 17 0479

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | M. R. HUMMON ET AL: "Measuring charge trap occupation and energy level in CdSe/ZnS quantum dots using a scanning tunneling microscope", PHYSICAL REVIEW. B, CONDENSED MATTER AND MATERIALS PHYSICS, vol. 81, no. 11, 1 March 2010 (2010-03-01) , pages 115439-1, XP055225254, US ISSN: 1098-0121, DOI: 10.1103/PhysRevB.81.115439 * abstract; figure 8 * | 6 | |
| X | CHAO LIU ET AL: "Novel nano-structured glasses containing semiconductor quantum dots: controlling the photoluminescence with phonons and photons", JOURNAL OF MATERIALS SCIENCE: MATERIALS IN ELECTRONICS, KLUWER ACADEMIC PUBLISHERS, BO, vol. 20, no. 1, 11 March 2008 (2008-03-11) , pages 282-285, XP019644548, ISSN: 1573-482X * abstract; figure 5 * | 6 | |

TECHNICAL FIELDS
SEARCHED       (IPC)

The present search report has been drawn up for all claims

| Place of search | Date of completion of the search | Examiner |
|---|---|---|
| Munich | 21 December 2017 | Lendroit, Stéphane |

## ANNEX TO THE EUROPEAN SEARCH REPORT
## ON EUROPEAN PATENT APPLICATION NO.

EP 17 17 0479

This annex lists the patent family members relating to the patent documents cited in the above-mentioned European search report.
The members are as contained in the European Patent Office EDP file on
The European Patent Office is in no way liable for these particulars which are merely given for the purpose of information.

21-12-2017

| Patent document cited in search report | Publication date | Patent family member(s) | Publication date |
|---|---|---|---|
| WO 2015186033 A1 | 10-12-2015 | EP 3152808 A1<br>JP 2017519366 A<br>US 2017085058 A1<br>WO 2015186033 A1 | 12-04-2017<br>13-07-2017<br>23-03-2017<br>10-12-2015 |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015186033 A

- US 6819692 B2

**Non-patent literature cited in the description**

- Colloidal Quantum Dots for Guided Wave Photonics : from Optical Gain to Ultrafast Modulation. **PIETER GEIREGAT.** The PhD thesis. Universiteit Gent, 2015